# EUROPEAN PATENT APPLICATION

(11) **EP 1 672 791 A2**
(43) Date of publication of application: **21.06.2006**
(21) Application number: 05112285.1
(22) Date of filing: 16.12.2005
(51) Int. Cl.: H03K 3/03

(54) **A glitch free controlled ring oscillator**

(30) Priority: 16.12.2004 IN DE25092004
(71) Applicant: STMicroelectronics Pvt. Ltd, Noida-201 301, Uttar Pradesh (IN)
(72) Inventor: Tiwari, Naveen, 110 053, Delhi (IN); Singh, Balwant, Greater Noida, UP (IN)
(74) Representative: Bosotti, Luciano

(57) **Abstract**

A glitch free controlled ring oscillator comprising a programmable delay chain connected to a gating and inverting means wherein a latching means is provided between said delay chain and said gating and inverting means for registering the clock state at the time of disabling the oscillator and setting the output of the oscillator to said registered clock state.

## Description

### Field of the Invention

The present invention relates to the field of ring oscillators In particular, it relates to a glitch free controlled ring oscillator.

### Background of the Invention

The controlled ring oscillators are commonly used for Integrated Circuit (IC) applications where trigger and stop operations of the oscillator are required to be precisely monitored and controlled.

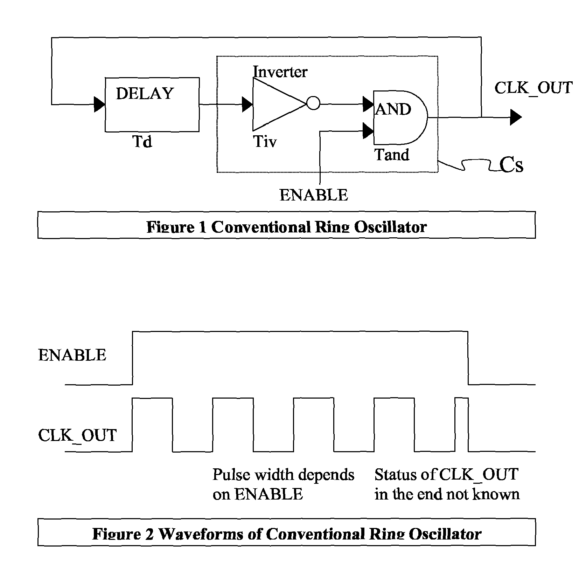

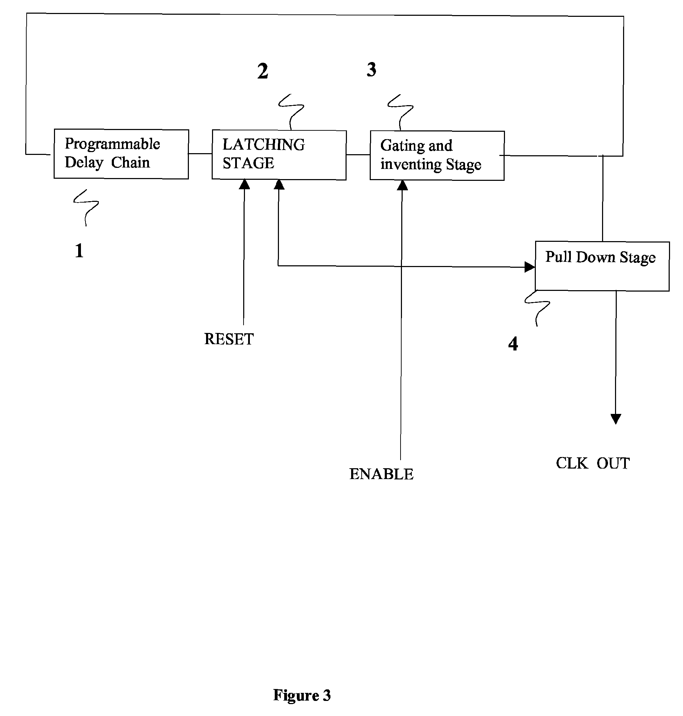

**Figure 1** shows a conventional oscillator consisting of a ring of delay elements or inverters **Td** and a final control stage **Cs**, which enables /disables the ring. The control stage Cs has an inverter Tiv and a logic gate Tand. The logic gate Tand receives output of inverter Tiv and enabling/disabling signal ENABLE and providing a clock output CLK_OUT. When ring is enabled by using ENABLE signal, the CLK_OUT has an oscillating waveform. Thus the conventional circuit acts as trigger start oscillator with a frequency F_{clk} =(1/(T_{Td}+T_{Tiv}+T_{Tand})*2), where T_{Td},T_{Tiv}T_{Tand} are the delays. This type of oscillators has major problems of producing glitches when disabled. Waveform in **figure 2** shows an output of the conventional oscillator between two disable signals. When the ENABLE signal is set to disable the oscillator, the CLK_OUT goes to '0' irrespective of present value which creates problem of minimum pulse width violation for the next stage or result in a glitch which can have adverse effects on the next stage. This would generate an error of the order of ~ (1/Fclk) for a synchronous system. Further the size of this glitch or pulse can vary at different process and voltage corners.

Thus, the conventional methods not only have errors with regards to the output clock but also it is difficult to estimate the error as the error has large process, voltage and temperature dependence. This is very critical particularly for the on-chip integrated circuits where an accuracy of few picoseconds is desired and it is expected that the design should have minimal impact of process, voltage and temperature variations.

### Objects and summary of the present Invention

It therefore is an object of the invention to obviate above and other limitations associated with prior art.

It is another object of the invention to provide a glitch free controlled ring oscillator, with a feature that it latches the final output value at the point when the ring oscillator is disabled so as to avoid minimum pulse width violation for the next stage.

It is an additional object of the invention is to provide a design, which can be used for phase locking.

To achieve above and other objects the invention provides a glitch free controlled ring oscillator comprising:
a programmable delay chain connected to a gating and inverting means wherein a latching means is provided between said delay chain and said gating and inverting means, said latching means and gating and inverting means are connected to a control signal for enabling/disabling the ring oscillator, for registering a clock state at the time of disabling the oscillator and setting the output of the oscillator to said registered clock state.

The said glitch free controlled ring oscillator further comprising a pulling down circuit connected to said gating and inverting means for pulling down said registered clock state, if said clock state is high after a period sufficient enough to avoid false edge or a glitch.

The said latching means comprising a first and second latch connected in parallel providing their outputs to a multiplexer, select line of the multiplexer and enabling / disabling line of said second latch is connected to said control signal of the ring oscillator such that the control signal disables said second latch to register a clock at the time of disabling oscillator and simultaneously selecting the output of said second latch to propagate through the multiplexer.

The said gating and inverting means comprising an inverter and logic gate connected in series such that the logic gate receives its one input as the control signal of the oscillator.

The invention also provides a ring oscillator a programmable delay chain connected to a gating and inverting means **wherein** a latching means is provided between said delay chain and said gating and inverting means, said latching means and gating and inverting means are connected to a control signal for enabling/disabling the ring oscillator, said control signal is received from a control block having a logic gate and a matching delay for registering a clock state at the time of disabling the oscillator and setting the output of the oscillator to said registered clock state, and a pulling down circuit having another programmable delay and logic gates for generating a clock and logic gates connected to said gating and inverting means for pulling down said registered clock state, if said clock state is high after a period sufficient enough to avoid false edge or a glitch.

The invention further provides a method for providing a glitch free controlled ring oscillator comprising the steps of:
- propagating a signal to generate a clock through a programmable delay chain of the oscillator, and;
- registering clock state at the time of disabling oscillator and setting the output of the oscillator to said clock state for providing a glitch free controlled oscillator.

The method further comprising a step of pulling down output of the oscillator if the registered clock state is high after a time sufficient enough to avoid a false edge or a glitch.

### Brief Description for the accompanying drawings

The invention will now described with reference to accompanying drawings.
Fig. 1 shows the conventional ring oscillator
Fig. 2 shows the waveforms of conventional ring oscillator
Fig. 3 shows the controlled ring oscillator according to present invention.
Fig. 4 shows a detailed diagram of the latching stage.
Fig. 5 shows the waveforms of the controlled ring oscillator according to the present invention.
Fig. 6 shows an explicit embodiment of the invention

### Detailed description of the present Invention

**Figure 3** shows controlled ring oscillator according to present invention. The ring oscillator of the invention comprises a programmable delay chain **1** connected to a gating and inverting stage **3** through a latching stage **2.** The latching stage **2** and gating and inverting stage **3** are connected to a control signal **ENABLE** for enabling/disabling the ring oscillator. When the control signal **ENABLE** disables the ring oscillator the latching stage **2** registers the clock state and sets the output of the oscillator to said registered clock state thereby avoiding any glitch or undesired edge. Further controlled ring oscillator also comprises a pulling down stage **4** connected to the output of the gating and inverting stage **3** for pulling down said registered clock state, if said clock state is high, after a period sufficient enough to avoid false edge or a glitch.

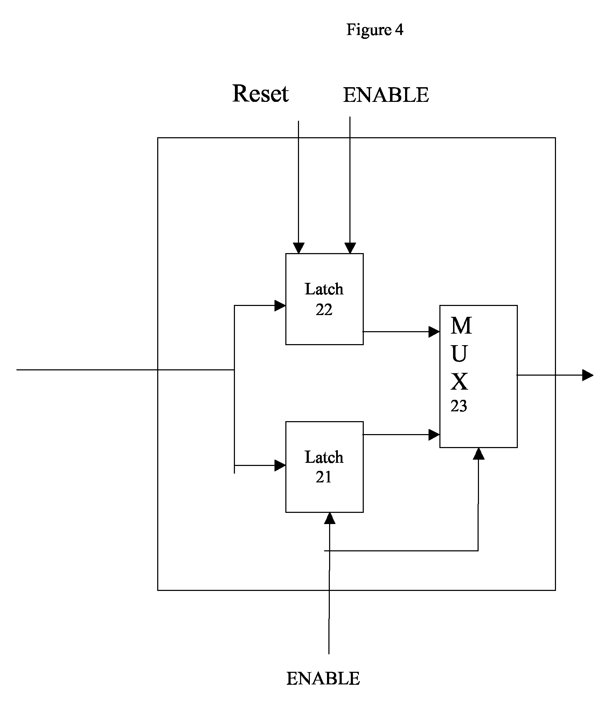

**Figure 4** a detailed diagram of the latching stage **2.** The latching stage **2** comprises a first latch **21** and a second latch **22** both receiving inputs from the programmable delay chain providing their outputs to a multiplexer **23,** select line of the multiplexer and enabling / disabling line of said second latch is connected to said control signal **ENABLE** of the ring oscillator such that the control signal **ENABLE** disables said second latch to register a clock at the time of disabling oscillator and simultaneously selecting the output of said second latch to propagate through the multiplexer.

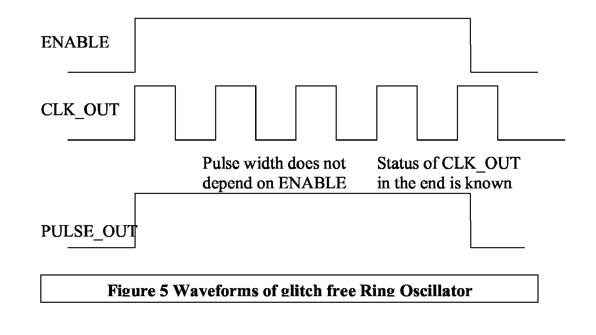

The ring oscillator is trigger started when ENABLE=1, and is trigger stopped when ENABLE=0. The RESET=0 resets the ring oscillator CLK_OUT logic value "0". **Figure 5** shows an output waveform of the ring oscillator of the instant invention. The operation of the circuit can be understood as follows:
(1) Reset Mode: In this mode RESET=0 and results in CLK_OUT with stable logic "0" value at their output.
(2) Initialization mode: This mode is used to setup the design for the triggering mode. This mode is follows after the Reset mode. This initialization is done by making RESET go at logic value "1" while the ENABLE pin is at the logic "0" value. In this mode CLK_OUT output have stable logic value "0" at their output. This is because pin 0 of multiplexers is transparent.
(3) Trigger Start Mode: This mode is enabled as soon as the ENABLE pin goes high with the RESET pin having a stable logic "1" value. In this mode the CLK_OUT are initially at value "0" as pin 0 of the multiplexers are transparent. As soon as the ENABLE goes high the pin 1 of multiplexers become transparent. This results in oscillating frequency at CLK_OUT.
(4) Trigger Stop Mode: This mode is enabled as soon as the ENABLE pin goes low (with the RESET pin having a stable logic "1" value). Just before this mode the CLK_OUT sees frequency of ring oscillator. As soon as the ENABLE goes low the multiplexers selects the input accordingly. This results in LATCH 21 to latch the value of ring oscillator at that moment. Thus, the CLK_OUT shows the status of ring oscillator when trigger stop signal is applied.
(5) Self Characterize Mode (not shown): This mode can be used to characterize the actual time period of ring oscillator at the output pad of a chip. This value is very useful for on-chip characterization of timings. This forces ring oscillator to start oscillating and the frequency division is performed to achieve a much lower frequency at output pad. The lower frequency is small enough to be measured at the tester.

Present invention provides following advantages as compare to the existing art.
- On-chip trigger start and stop ring oscillator is proposed.
- Error is minimized by the method proposed over a range of process, voltage and temperature.
- Glitch free output.
- Area efficient with very small area penalty.

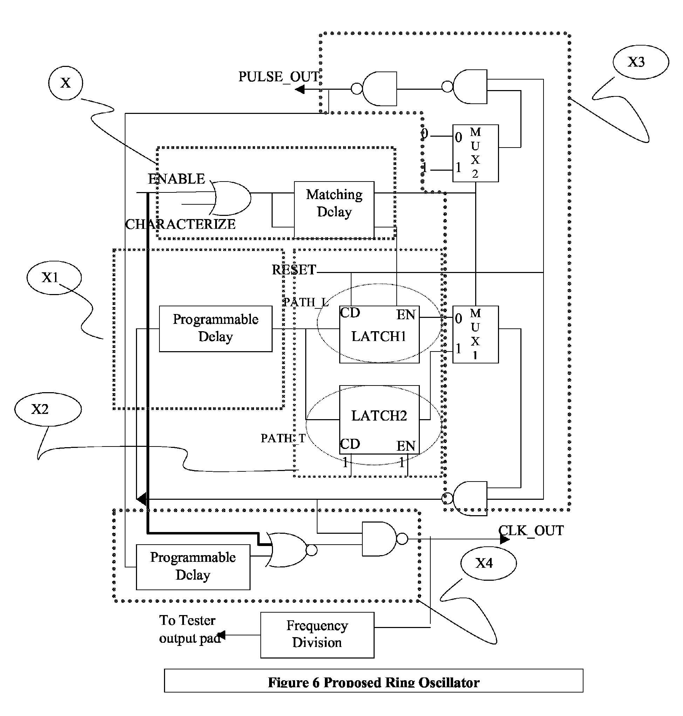

**Figure 6** shows one possible explicit embodiment of the instant invention. According to this embodiment of the invention, the glitch free controlled ring oscillator has **programmable delay chain** of block **X1** connected to **LATCH 1 and LATCH 2** of Block **X2** in parallel providing their outputs to a multiplexer **MUX1** of the gating block **X3.** Select line of the multiplexer **MUX1** and enabling / disabling line of **LATCH1** is connected to controlling block **X** of the ring oscillator such that the control block disables said **LATCH 1** to register a clock at the time of disabling oscillator and simultaneously selecting the output of said **LATCH 2** to propagate through the multiplexer **MUX 1.** The **LATCH 2** and **LATCH 1** are provided between said programmable delay chain and said gating and inverting block **X3,** said **LATCH 2** and gating and inverting block **X3** are connected to a control block **X** for enabling/disabling the ring oscillator, for registering a clock state at the time of disabling the oscillator and setting the output of the oscillator to said registered clock state. Block **X4** is the pulling down circuit connected to said gating and inverting block **X3** for pulling down said registered clock state, if said clock state is high after a period sufficient enough to avoid false edge or a glitch.

The control block **X** has an AND gate receiving an enable signal and a characterize signal and providing its output to a matching delay circuit for matching delay. The output of the matching delay circuit is used as the control signal from the glitch circuit.

The pulling down circuit **X4** has **programmable delay** for generating a clock and logic gates for enabling a pull down operation when desired. The generated clock frequency of the logic block can be tested at he output pad as shown.

## Claims

1. A glitch free controlled ring oscillator comprising a programmable delay chain connected to a gating and inverting means **wherein** a latching means is provided between said delay chain and said gating and inverting means for registering the clock state at the time of disabling the oscillator and setting the output of the oscillator to said registered clock state.

2. A glitch free controlled ring oscillator as claimed in claim 1 further comprising a pulling down circuit connected to said gating and inverting means for pulling down said registered clock state, if said clock state is high after a period sufficient enough to avoid false edge or a glitch.

3. A glitch free controlled ring oscillator as claimed in claim 1 wherein said latching means comprising a first and second latch connected in parallel providing their outputs to a multiplexer, select line of the multiplexer and enabling / disabling line of said second latch is connected to said control signal of the ring oscillator such that the control signal disables said second latch to register a clock at the time of disabling oscillator and simultaneously selecting the output of said second latch to propagate through the multiplexer.

4. A glitch free controlled ring oscillator as claimed in claim 1 wherein said gating and inverting means comprising an inverter and logic gate connected in series such that the logic gate receives its one input as the control signal of the oscillator.

5. A method for providing a glitch free signal output from controlled ring oscillator comprising the steps of:
- propagating a signal to generate a clock through a programmable delay chain of the oscillator, and;
- registering clock state at the time of disabling the oscillator and setting the output of the oscillator to said clock state for providing a glitch free signal output.

6. A method for providing a glitch free signal output from controlled ring oscillator as claimed in claim 5 further comprising a step of pulling down output of the oscillator if the registered clock state is high after a time sufficient enough to avoid a false edge or a glitch.

7. A glitch free controlled ring oscillator comprising a programmable delay chain connected to a gating and inverting means **wherein** a latching means is provided between said delay chain and said gating and inverting means, said latching means and gating and inverting means are connected to a control signal for enabling/disabling the ring oscillator, said control signal is received from a control block having a logic gate and a matching delay for registering a clock state at the time of disabling the oscillator and setting the output of the oscillator to said registered clock state, and a pulling down circuit having another programmable delay and logic gates for generating a clock and logic gates connected to said gating and inverting means for pulling down said registered clock state, if said clock state is high after a period sufficient enough to avoid false edge or a glitch.
